# EUROPEAN PATENT SPECIFICATION

(11) **EP 1 329 141 B1**
(45) Date of publication and mention of the grant of the patent: **13.07.2005**
(21) Application number: 01981882.2
(22) Date of filing: 16.10.2001
(51) Int. Cl.: H05K 1/00, B29C 45/00, B29C 59/00

(54) **FINE FEATURED MOLDINGS OF LIQUID CRYSTALLINE POLYMERS**
FEINSTRUKTURIERTE FORMTEILE AUS FLÜSSIGKRISTALLPOLYMEREN
PIECES MOULEES A MOTIFS FINS CONSTITUEES DE POLYMERES A CRISTAUX LIQUIDES

(30) Priority: 17.10.2000 US 240996 P
(43) Date of publication of application: 23.07.2003
(73) Proprietor: E.I. DUPONT DE NEMOURS AND COMPANY, Wilmington, Delaware 19898 (US)
(72) Inventor: KING, Randal, D., Kennett Square, PA 19348 (US); TASSI, Nancy, G., Gibbstown, NJ 08027 (US)
(74) Representative: Abitz, Walter, Dr.-Ing.
(86) International application number: PCT/US2001/042745
(87) International publication number: WO 2002/034017

(56) References cited:
- EP-A- 0 689 927
- WO-A-96/35971
- US-A- 5 705 254
- US-A- 5 736 191
- US-B1- 6 315 937

## Description

### FIELD OF INVENTION

The field of invention relates to liquid crystalline polymers, articles which may be melt formed therefrom with very fine features such as ridges and/or channels molded therein, applications using such articles, and processes for making such articles and applications.

### BACKGROUND OF INVENTION

The ability to form narrow and/or closely spaced lines, for example in the form of ridges and grooves or similar structures, is an important industrial technology, and is used to form diffraction gratings of various types, circuit boards, encapsulants and interconnects for microelectronics, gravure and other types of printing plates, substrates for chemical and biological microreactors, and substrates for various microarrays such as biological and chemical microarrays.

While such configurations can be formed directly, as by laser cutting grooves, such methods are slow and expensive, and usually used for low volume and/or expensive items. For mass produced items such as circuit boards, some form of printing is usually used to produce the outline of the desired pattern, and then a usually complex series of steps is used to generate the ridges and grooves and to add metal in the appropriate places to form a printed circuit. This complexity often leads to higher cost, and in many cases the need to use and dispose of environmentally unfriendly chemicals. Such methods are outlined in C. F. Coombs, Jr., Ed., Printed Circuit Handbook, 4^{th} Ed., McGraw-Hill, New York, 1995, chapters 3 and 4. Therefore, better methods of forming patterns on substrates for printed circuit boards, diffraction gratings, printing plates, microelectronic interconnects, and microreactors are desired.

U.S. Patents 4,532,152 and 4,689,103 describe the use of plastics, for instance poly(ethylene terephthalate), for the preparation of circuit boards by directly injection molding of channels into a plastic part, and then metalization of the resulting part. Channels are preferably about 25 to about 250 µm deep, but no dimension is given for the separation of the channels, nor is any mention made of using LCPs.

The use of LCPs for circuit boards and various other electronic devices has also been suggested, see for instance European Patent (Application) 312,268, 311,232, 365,846, 353933 and 407,129, but none of these documents suggests directly melt molding patterns into the LCP part.

US 5 736 191 discloses a process for selective metalization for electrically isolating areas of a substrate. Materials for the substrate include liquid crystal polymers. The substrate can be made by injection molding into a preconfigured mold. Microridges can be created on the substrate during the injection molding process or in a separate molding step. The dimensions of the microridges disclosed therein are far remote from the dimensions of the topographical features of the present invention.

US 5 705 254 discloses a plastic molded article which is formed by injection molding using a mold with a surface shaped by forming machining marks in the form of recesses over the entire mold surface. Neither is a deliberately melt molded topographical feature, nor the use of liquid crystalline polymers disclosed therein.

EP 0 689 927 A discloses a film having a roughened surface. The film is made of a liquid crystalline polymer, and has surface recessions covering at least about 25% of the area of the surface. The film is made by pressing an embossing means against the film surface at a temperature about 15-75°C below the melting point of the polymer. The embossed film has improved resistance to abrasion.

WO 96/35971 A discloses a micro relief element which comprises: a) a first layer of a first substrate, the first layer having a receptive surface capable of retaining a relief forming polymer; b) an overlay of a desired thickness of the relief forming polymer over the receptive surface; and c) at least one relief feature formed from the relief forming polymer and which protrudes above the overlay; structures and elements comprising such micro relief element; micro-optical, micro-fluidic, micro-electrical and micro-chemical applications thereof; and a method and apparatus for the preparation thereof.

US 6 315 937 discloses a minutely working method of and apparatus for opposing the surface of a transfer member having a concave or convex pattern formed on the surface thereof and the surface of a workpiece to each other, heating the transfer member and thermally expanding the transfer member in the direction of a normal to the surface thereof to thereby transfer the concave or convex pattern to the workpiece.

### SUMMARY OF INVENTION

Our invention relates to a shaped part, comprising, a polymer portion of which a major proportion is a liquid crystalline polymer, and which has deliberately melt molded into one or more surfaces of said part a topographical feature measured parallel to said surface of less than 15 µm in its smallest dimension, or said topographical feature measured perpendicular to said surface of less than 15 µm in its smallest dimension, or both.

The invention also relates to a process for making a molding, comprising, forming a molten polymer portion of which a major proportion is a liquid crystalline polymer, placing said molten polymer portion into a closed mold under at least 1 MPa pressure, said mold having on one or more of its surfaces one or more topographical features measured parallel to said surface of less than 15 µm in its smallest dimension or measured perpendicular to said surface of less than 15 µm in its smallest dimension, or both, and then cooling said polymer portion to solidify it, to produce said molding which has melt molded into one or more surfaces of said molding one or more topographical features measured parallel to said surface of less than 15 µm in its smallest dimension or measured perpendicular to said surface of less than 15 µm in its smallest dimension, or both.

Particular embodiments of the invention are the subject of the respective dependent claims.

### BRIEF DESCRIPTION OF THE DRAWINGS

Figures 1, 2 and 3 show various preferred types of topographical features of the present invention, and some preferred dimensions of those features.
Figure 4 shows 100µm ridges/spaces on a preferred steel mold insert of our invention.
Figure 5 shows 100µm channels/ridges of a preferred plaque molded using the steel mold insert of Figure 4.

### DETAILED DESCRIPTION OF PREFERRED EMBODIMENTS

By a liquid crystalline polymer herein is meant a polymer which is a liquid crystalline polymer by the "TOT Test" as described in U.S. Patent 4,118,372.

By "melt molded" or "melt formed" is meant that a thermoplastic polymer such as an LCP is melted, formed into a shape such as in a mold, and then cooled to solidify the thermoplastic polymer into a shaped article.

By a "topographical feature" is meant a three dimensional feature on the surface of an object, such as a molding. The size(s) of features on a surface may be measured parallel to that surface, or perpendicular to that surface (also referred to herein as the depth). These features are deliberately molded into the surface of the molding produced, and usually have desired shape(s) and/or dimension(s). Topographical features do not include random defects in the molding, such as pits, random channels, or high spots. Usually these topographical features are reproducible in repetitive moldings with the same mold.

The polymer portion molded herein contains a majority of one or more LCPs by volume, based on the total amount of thermoplastic by volume in the polymer portion. In one preferred embodiment the polymer portion contains one or more LCPs as the only thermoplastics present, more preferably contains one LCP. Useful LCPs include those described in U.S. Patents 3,991,013, 3,991,014 4,011,199, 4,048,148, 4,075,262, 4,083,829, 4,118,372, 4,122,070, 4,130,545, 4,153,779, 4,159,365, 4,161,470, 4,169,933, 4,184,996, 4,189,549, 4,219,461, 4,232,143, 4,232,144, 4,245,082, 4,256,624, 4,269,965, 4,272,625, 4,370,466, 4,383,105, 4,447,592, 4,522,974, 4,617,369, 4,664,972, 4,684,712, 4,727,129, 4,727,131, 4,728,714, 4,749,769, 4,762,907, 4,778,927, 4,816,555, 4,849,499, 4,851,496, 4,851,497, 4,857,626, 4,864,013, 4,868,278, 4,882,410, 4,923,947, 4,999,416, 5,015,721, 5,015,722, 5,025,082, 5,086,158, 5,102,935, 5,110,896, and 5,143,956, and European Patent Application 356,226. One preferred type of LCP is an aromatic polyester or poly(ester-amide), preferably an aromatic polyester.

In another preferred embodiment, the polymer portion comprises another thermoplastic, which is preferably an amorphous polymer, such as poly(ether-ether-ketone) (commonly called PEEK), a novolac, or Ultem, which is a poly(ether-imide) manufactured by General Electric Co.

It is also preferred that the LCP be of relatively low molecular weight, or said another way have a relatively low melt viscosity, preferably a melt viscosity of 1 to 200 Pa·s, more preferably 5 to 100 Pa·s, and especially preferably 10 to 50 Pa·s. It is preferred that the low molecular weight LCP is made by the method described in World Patent Application 99/52978. Aside from the thermoplastic polymer(s) themselves, the polymer portion may also contain other ingredients normally found in such polymers, such as colorant, pigments, reinforcing agents, fillers, antioxidants, and others. Useful fillers/reinforcing agents and pigments include talc, mica, calcium carbonate, silica, quartz, titanium dioxide, thermoset polymer(s), and carbon black. In all cases any solid particulate material in the polymer portion should preferably have a maximum particle size less than the smallest dimension of any topographical feature, preferably less than half the size of the smallest dimension of any topographical feature, to avoid having the filler cause defects in the topographical feature(s). Materials such as quartz may also be used to modify the coefficient of thermal expansion of the molding. The solid particulate materials may be coated with materials such as functionalized silanes, titanates or surfactants, to modify their surface characteristics.

The molding process may be any melt molding process known for thermoplastics such as compression molding or injection molding, although injection molding is preferred (see for instance H. Mark, et al., Ed., Encyclopedia of Polymer Science and Engineering, Vol. 8, John Wiley & Sons, New York, 1987, p. 102-138). Where applicable, it is preferred that the molding be carried out by heating the polymer to a relatively high temperature above its melting point and/or glass transition temperature, and/or injecting the polymer into the mold at relatively high speed, and/or using a relatively high pressure to pack the mold, and/or using a relatively high mold temperature in injection molding (but below the melting point of the polymer, or below glass transition point if the LCP is amorphous). Such conditions are illustrated in the Examples.

The sizes and shapes of the topographical features may vary widely. There may be one or more grooves or channels, in the case of more than one separated by ridges, or there may simply be one or more ridges elevated from a planar surface. Any of these features may be present in random configuration(s), or may be present in an ordered array, such as parallel. There may be features protruding from the surfaces shaped such as skyscrapers, pyramids or obelisks, either in a random configuration or in some ordered configuration. And there may be any combinations of these or other types of features. Depressions part way, or completely through the molded part may also be present.

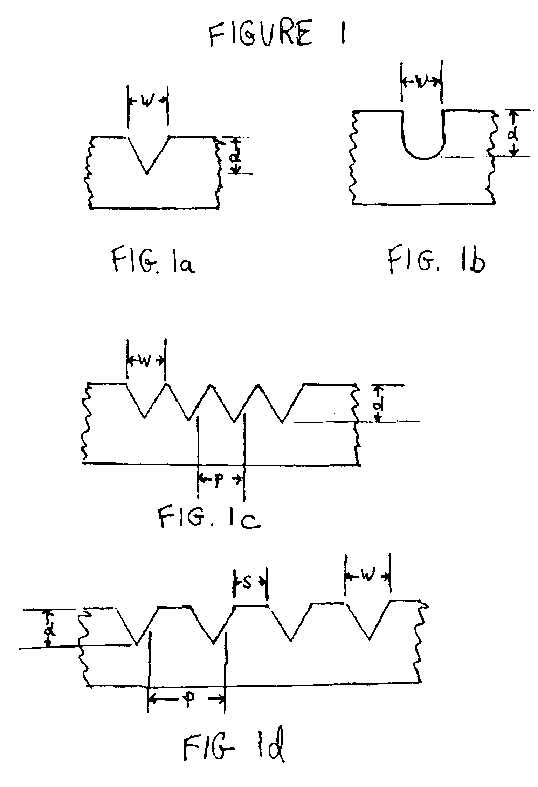

The dimensions of the topographical features may be varied of course by varying those dimensions in the mold. Figure 1 shows the cross sections of various grooves and groove configurations. For example, for a V-shaped groove (Figure 1a) the width "w" will be taken as the width across the top of the groove. For a "U" shaped groove it will be taken anywhere along the "legs" of the "U", as shown in Figure 1b. The depth "d" of the groove will be taken from the top of the groove to the bottom as shown in Figures 1a and 1b. A series of grooves, especially a series of parallel grooves, will have groove widths "w" and depths "d" as shown for example in Figures 1c and 1d. A series of grooves close together also creates a series of ridges. The grooves may have no separation, as shown in Figures 1c, or may have separation, as shown in Figure 1d. The separation "s", a measurable topographical feature, is shown in Figure 1d. A series of regularly spaced parallel grooves (and their accompanying ridges) also has another dimension, pitch, "p", shown on Figures 1c and 1d. This is the topographical feature dimension for one repetition of a groove and ridge.

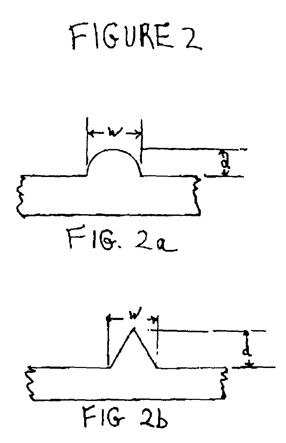

Figures 2a and 2b show the cross section of various isolated ridges and their depths "d" and their widths "w".

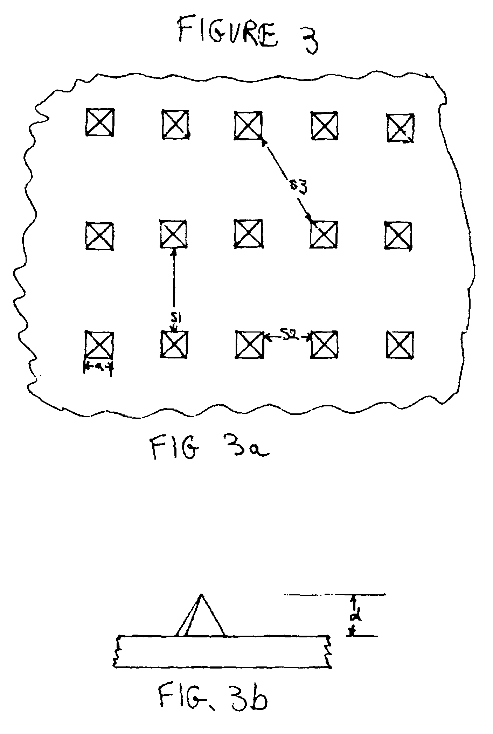

Figure 3a shows a top view of a series of regularly spaced pyramid-like topographical features on a planar surface, while Figure 3b shows a side view of one of these features. Among the topographical dimensions which can be measured are one side of the pyramid base "a", the height of pyramid "d", and the various spacings between the pyramids, "s1", "s2", and "s3". The pyramids shown are the same size and spacing, but both the regularity of the pyramid shapes and sizes, and the spacing of the pyramids may be varied from regular to random. There may be more than one shape of topographical feature present in the same molding. Similar types of dimensions may be envisioned for other types of topographical features.

Preferred types of topographical features are a series of grooves and their accompanying ridges, or isolated grooves (including multiple grooves not relatively close to one another and/or not running parallel to each other). Another preferred type of topographical feature is a series of elevated spots (for example on the end or side of pyramids, cylinders, cones, rectangular solids, or cubes) extending from an essentially planar surface, preferably in some sort of regular or repeating array. Another type of preferred topographical feature is a cylindrical depression or hole part way or completely through the molded part. If part way, the depth of this or similar feature is the distance from the surface to the bottom of the depression.

Preferably the maximum size of a topographical feature parallel to the surface is 15 µm or less, more preferably 10 µm or less, especially preferably 5 µm or less, very preferably 1 µm or less, immensely preferably 0.5 µm or less, and extremely preferably 0.1 µm or less. A preferred minimum dimension parallel to the molding surface for a topographical feature is 0.001 µm or more, more preferably 0.01 µm or more, very preferably 0.1 µm or more and especially preferably 0.5 µm or more. Preferred minimum and maximum dimensions may vary according to the particular use of the molded part. For dimensions of topographical features measured perpendicular to the molding surface (depth), it is preferred that the depth is 10 µm or less, more preferably 5 µm or less, especially preferably 2 µm or less, very preferably 1 µm or less, immensely preferably 500 nm or less, extremely preferably 100 nm or less, and exceedingly preferably or less, extremely preferably 100 nm or less, and exceedingly preferably 50 nm or less. A preferred minimum dimension perpendicular to the molding surface for a topographical feature is 0.1 nm or more, more preferably 0.5 nm or more, very preferably 1 nm or more and especially preferably 5 nm or more. Any of the preferred minimum and maximum dimensions either parallel to or perpendicular to the surface may be combined, as can any preferred dimension parallel to and perpendicular to the surface.

The molding made herein are directly useful as, or useful in the manufacture of, diffraction grating of various sorts, such as monochromators and holographic grating, circuit boards, printing plates, microelectronic interconnects, and microreactors. Since topographic features on the order of size of the wavelength of light may be molded into the LCP part, these parts may be used for diffraction of visible light and other electromagnetic radiation. For example to be useful as diffraction gratings, they may be metal coated, as by electroless plating, electroplating, or plasma coating.

For use as circuit boards, a number of different methods may be used to obtain conductive pathways on the surface(s) of the molding. The polymer portion may be filled with a mineral filler such as calcium carbonate to improve the adhesion of a metal, usually copper. After formation of the molding, metal adhesion may be improved by any known method, such as etching the surface with various chemicals, by plasma or corona etching, or by mechanical abrasion using very fine grit abrasives.

In one very simple method the metallic conductor pattern is produced on one or more of the mold surfaces, as by plating, and then the LCP is molded around it. The LCP surface therefore has molded into it the metallic conductor pattern. In order that the metallic conduction come out of the mold on the LCP surface, the mold surface may be treated with a release agent, and/or the surface of the metal pattern to be adhered to the LCP may be coated with an adhesion promoting agent such as benzotriazole.

If the metallic conductors are to be formed in channels below the surface of the molding, a conductive ink may be applied by squeegee into the channels and the channels electroplated with the metal. In another method a Pd catalyst for electroless plating may be applied to the surface of the entire molding, and then removed from the raised (nonchannnel portions) by abrasion. Alternatively, after the metal has been plated onto the surface (by electroless and/or electroplating), the metal on the raised surface may be removed by abrasion. In another altemative a resist may be added to the already metal plated channels and the other metal on the surface removed by chemical etching. If the conductive or other type of pattern is formed above the general surface of the part, it may be coated by roll coating leaving the lower portions of the surface uncoated. The coated portion may then be treated as needed. Some of the above and other metalizing procedures are also described in U.S. Patents 4,532,152 and 4,689,103.

Holes in the circuit board may be put in place by drilling methods such as laser drilling, or may be molded into the board, e.g. by the use of pins in the mold. One or both sides of the board may have a pattern molded into it. Additional layers of circuitry may be added by sequentially molding another layer of LCP onto the first molding and then metalizing. Holes connecting the two or more layers may be drilled or may be formed in the molding by pins.

Molds for the process may be prepared by a variety of methods. For example, a dense metal surface may be laser, mechanically, or chemically etched to form the desired pattern. Mold inserts having the desired pattern may be made by well-known methods similar to those used for "stampers" for making optical compact discs. This allows for rapid changing of the pattern to be molded in a single mold. A multicavity mold may be used to mold more than one device (circuit board, diffraction grating, etc.) at a time. Alternatively one large piece containing two or more devices may be molded and later cut apart at some stage of the manufacture to produce multiple devices. More than one large piece may be molded at a time in a multicavity mold.

Using LCPs as the base polymer has several advantages over using many other types of polymers. Many LCPs have one or more of good heat resistance, good chemical resistance, low flammability and other advantages. This allows the molding produced to be used where corrosive chemicals and/or solvents are present, and/or operations in which high temperatures are encountered, such as in soldering operations on circuit boards.

Melt viscosity is determined on a Kayeness rheometer (Kayeness, Inc., RD#3, Box 30, E. Main St., Honeybrook, PA 19344 U.S.A.). Generally, the Kayeness rheometer can readily and routinely measure melt viscosities down to about 50 Pa·s and 1000 1/s. However, great care is needed to gauge viscosity below this value of 50 Pa·s.

Melt viscosity of above 50 Pa·s are measured using a die having a hole radius of 0.5 mm (0.02") by 2.0 cm (0.80") long using a melt time of 360 sec. Melt viscosities of less than 50 Pa·s are measured using a (nonstandard) die with a die hole radius of 0.20mm (0.0078") by 3.48cm (1.2") long. This small diameter die was custom fabricated using commercially available EDM type drills. This small 0.20 mm die gives a more accurate measurement of viscosity under 50 Pa·s than a 0.5 mm radius die and can measure viscosity levels of 0.4 Pa·s with an accuracy of about 0.1 Pa·s. For both dies, a preheating time of at least five minutes and preferably about thirty minutes is required in between samples (when measuring viscosity on multiple samples) to minimize variability in viscosity values. At a viscosity level of about 20 Pa·s at 1000 1/s and below, measuring viscosity is quite a challenge due to sample drooling from the die during the hold portions of the measurement test. The drooling can be effectively minimized by manually plugging the orifice during the preheat and in between measurements (multiple measurements are usually made within one Kayeness run). At a viscosity level of about 10 Pa·s, and especially below about 5 Pa·s, the extremely fluid melt tends to seep in between the Kayeness piston and cylinder. The variability of these measurements may be reduced by making multiple measurements at one shear rate until a steady state viscosity is reached (indicating that no more melt is seeping between the piston and cylinder walls).

### EXAMPLES

The following Examples 1-2 illustrate preferred embodiments of our invention. Our invention, of course, is not limited to Examples 1-2.

### EXAMPLE 1

Plaques were molded from an LCP composition using a steel insert in a Nisei FN-4000-1 injection molding machine.

The steel insert had raised, serpentine lines approximately 20-30 µm high, and nominal widths from 20 to 100µm. This insert was prepared using a photoimaging and chemical milling process, with a silver halide phototool, an aqueous-processed dry film photoresist, and ferric chloride etchant. Lines and spaces of the serpentine patterns on the phototool are nominally equal. On the milled insert, the tops of the raised lines are several µm narrower, and spaces, several µm wider, than the phototool, because of etching effects. Examination by optical microscope showed that the line patterns down to the 40µm lines/spaces were etched uniformly. The 30 µm patterns were wavy and damaged, while the 20µm were not resolved.

The LCP composition used was as follows:
70 wt% LCP having monomers HQ/BP/T/N/HBA in a molar ratio of 50/50/70/30/320
30 wt% CE Minerals 44CSS fused silica

Injection molding conditions were as follows:
Barrel temperatures: nozzle: 334°C; front: 350°C; mid: 342°C; rear: 315°C
Ram speed: 16 mm/sec
Peak pressure: 30 MPa
Injection + hold time: 5 sec

A total of 120 plaques were made, with each resulting plaque having dimensions of 3 inches x 5 inches x 1/16 inch.

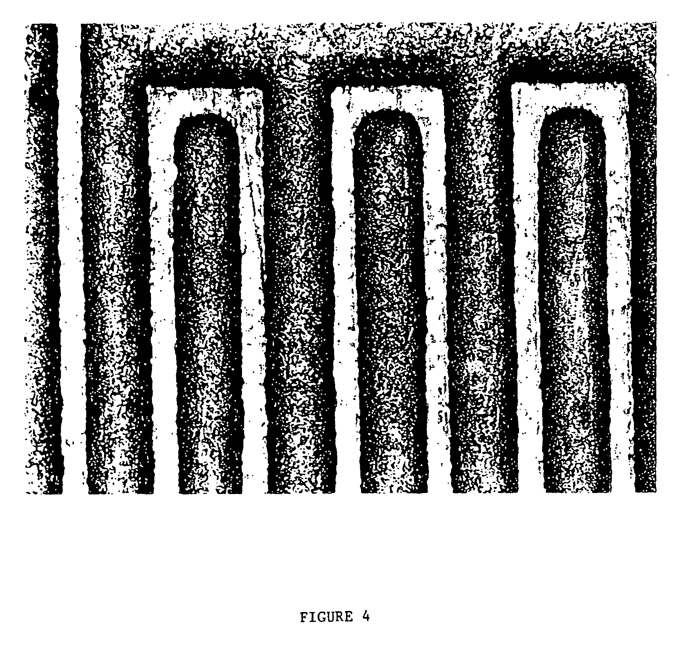

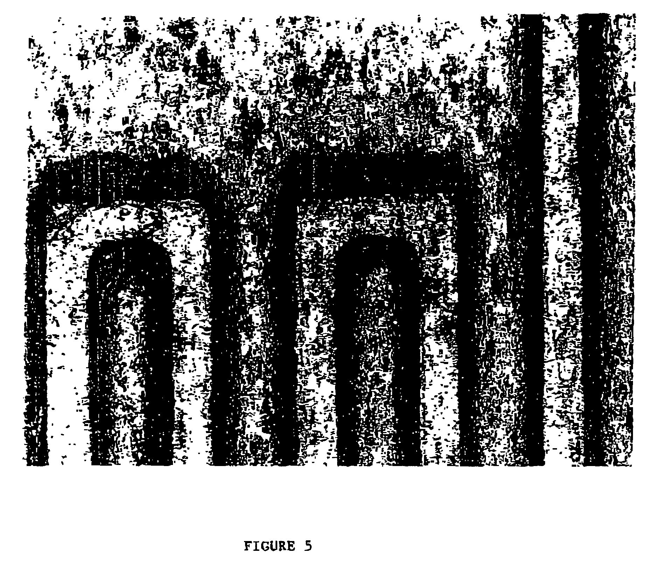

Examination of 11 plaques produced under various molding conditions per a designed experiment probing the effects of molding conditions on replication by optical and scanning electron microscopes showed that the LCP replicated the structure of the steel insert well down to the 100 µm lines/spaces, showing channels corresponding to the raised lines on the steel insert. Below 100 µm lines/spaces, the LCP replicated the mold structure fairly well, but did show some defects that were small in relation to the overall pattern, and not significant for circuit board purposes. Figure 4 shows the 100µm line/space area on the steel insert. Figure 5 shows the corresponding area on one of the molded plaques. Magnification of the LCP plaque in Figure 5 is slightly higher than the steel insert in Figure 4.

### EXAMPLE 2

This example illustrates a preferred squeegee/blade method of laying down conductive paths in channels below the surface of a molded article.

A preliminary study was conducted to determine which ink to use, based on solderability.

The following three inks were printed and soldered on LCP plaques:
CB230 (available from DuPont Company, Wilmington, DE)
CB220 (available from DuPont Company, Wilmington, DE)
4929N (available from DuPont Company, Wilmington, DE)
CB230 was the only polymer ink to show good solderability.

In addition to the CB230 ink, the following materials and equipment were used in this example:
Red 70 durometer squeegee
Metal blade
White 90 durometer squeegee
30 micron sandpaper
Sears Hand Sander
Green Scotchbrite pad with water
40m thick Hitachi Chemical Co. coverlay
Hewlett Packard 3457A Multimeter
Box oven at 170 C
62Sn/36Pb/2Ag Solder at 220 C
CB230 was applied to LCP substrates described in Example 1, above, either using: Red 70 durometer squeegee, Metal Blade, or White 90 durometer squeegee.

A preliminary investigation was conducted, where it was found that:
- the Red 70 durometer squeegee conformed to the substrate. With little pressure, this squeegee left a lot of excess ink on the surface. With heavy pressure, the squeegee dipped into the traces and did not allow ink to remain.
- the metal blade sheared the edges of the traces (i.e., damaged the LCP).
- the White 90 durometer squeegee provided the best results when using a double pass. The first pass was tilted so there was about a 20 degree angle between the squeegee and the substrate. The second pass had less tilt, 45-50 degree angle to substrate and used less pressure. The first pass filled the traces and the second cleaned the excess ink off the surface. Excess ink was minimized even more when cutting a template to cover non-printed areas.

Thus, 5-6 LCP substrates were prepared using the White 90 durometer squeegee and method described above, followed by curing at 170 C for 30 minutes. Surfaces were cleaned using either the 30 micron sandpaper (manual hand sanding), the Sears Hand Sander (automatic sanding), or the Green Scotchbrite pad with water.

All methods cleaned the surface well, but resulted in breakdown of the silver-coated copper in the CB230 (which can effect soldering). With manual hand sanding, you can select areas to be more/less aggressive (although even when using manual hand sanding, some areas of the silver-coated copper are broken down leaving a copper surface, which may effect soldering).

Resistivity measurements using the Hewlett Packard 3457A Multimeter were taken on one of the manually hand sanded substrates. The results are set forth below in Table 1.

**TABLE 1**

| Line/space (microns) | Resistivity (kohms) |
|---|---|
| 70 | Open |
| 80 | 3.24 |
| 90 | Open |
| 100 | 6.33 |

While this invention has been described with respect to what is at present considered to be the preferred embodiments, it is to be understood that the invention is not limited to the disclosed embodiments. To the contrary, the invention is intended to cover various modifications within the scope of the appended claims.

## Claims

1. A shaped part, comprising, a polymer portion of which a major proportion is a liquid crystalline polymer, and which has deliberately melt molded into one or more surfaces of said part a topographical feature measured parallel to said surface of less than 15 µm in its smallest dimension, or said feature measured perpendicular to said surface of less than 15 µm in its smallest dimension, or both.

2. The shaped part as recited in claim 1 wherein said topographical feature measured parallel to said surface of less than 10 µm in its smallest dimension, or said feature measured perpendicular to said surface of less than 10 µm in its smallest dimension, or both.

3. The shaped part as recited in claim 1 wherein said topographical feature measured parallel to said surface of less than 5 µm in its smallest dimension, or said feature measured perpendicular to said surface of less than 5 µm in its smallest dimension, or both.

4. The shaped part as recited in claim 1 wherein said topographical feature measured parallel to said surface is less than 1 µm in its smallest dimension, or said feature measured perpendicular to said surface is less than 1 µm in its smallest dimension, or both.

5. The shaped part as recited in claim 1 wherein said topographical feature is one or more rides, grooves, or channnels.

6. The shaped part as recited in claim 1 wherein said topographical feature is present in an ordered array.

7. A process for making a molding, comprising, forming a molten polymer portion of which a major proportion is a liquid crystalline polymer, placing said molten polymer portion into a closed mold under at least 1 MPa pressure, said mold having on one or more of its surfaces one or more topographical features measured parallel to said surface of less than 15 µm in its smallest dimension, or said feature measured perpendicular to said surface of less than 15 µm in its smallest dimension, or both, and then cooling said polymer portion to solidify it, to produce said molding which has deliberately melt molded into one or more surfaces of said molding a topographical feature measured parallel to said surface of less than 15 µm in its smallest dimension, or said feature measured perpendicular to said surface of less than 15 µm in its smallest dimension, or both.

8. The process as recited in claim 7 wherein said topographical feature measured parallel to said surface of less than 10 µm in its smallest dimension, or said feature measured perpendicular to said surface of less than 10 µm in its smallest dimension, or both.

9. The process as recited in claim 7 wherein said topographical feature measured parallel to said surface of less than 5 µm in its smallest dimension, or said feature measured perpendicular to said surface of less than 5 µm in its smallest dimension, or both.

10. The process as recited in claim 7 wherein said topographical feature measured parallel to said surface is less than 1 µm in its smallest dimension, or said feature measured perpendicular to said surface is less than 1 µm in its smallest dimension, or both.

11. The process as recited in claim 7 wherein said topographical feature is one or more rides, grooves, or channnels.

12. The process as recited in claim 7 wherein said topographical feature is present in an ordered array.

## Patentansprüche

1. Formteil mit einem Polymerabschnitt, der als Hauptanteil ein Flüssigkristallpolymer aufweist, wobei das Formteil ein absichtlich in eine oder mehrere Oberflächen des Teils eingeschmolzenes topographisches Merkmal aufweist, das in seiner parallel zu der Oberfläche gemessenen kleinsten Abmessung kleiner als 15 µm ist oder in seiner senkrecht zu der Oberfläche gemessenen kleinsten Abmessung kleiner als 15 µm ist, oder beides.

2. Formteil nach Anspruch 1, wobei das topographische Merkmal in seiner parallel zu der Oberfläche gemessenen kleinsten Abmessung kleiner als 10 µm ist, oder wobei das Merkmal in seiner senkrecht zu der Oberfläche gemessenen kleinsten Abmessung kleiner als 10 µm ist, oder beides.

3. Formteil nach Anspruch 1, wobei das topographische Merkmal in seiner parallel zu der Oberfläche gemessenen kleinsten Abmessung kleiner als 5 µm ist, oder wobei das Merkmal in seiner senkrecht zu der Oberfläche gemessenen kleinsten Abmessung kleiner als 5 µm ist, oder beides.

4. Formteil nach Anspruch 1, wobei das topographische Merkmal in seiner parallel zu der Oberfläche gemessenen kleinsten Abmessung kleiner als 1 µm ist, oder wobei das Merkmal in seiner senkrecht zu der Oberfläche gemessenen kleinsten Abmessung kleiner als 1 µm ist, oder beides.

5. Formteil nach Anspruch 1, wobei das topographische Merkmal aus einer oder mehreren Schneisen, Rillen oder Kanälen besteht.

6. Formteil nach Anspruch 1, wobei das topographische Merkmal in einer geordneten Anordnung vorhanden ist.

7. Verfahren zur Herstellung eine Formteils, mit dem folgenden Schritten: Herstellen eines geschmolzenen Polymerabschnitts, der als Hauptanteil ein Flüssigkristallpolymer aufweist, Einbringen des geschmolzenen Polymerabschnitts in eine geschlossene Pressform unter einem Druck von mindestens 1 MPa, wobei eine oder mehrere Flächen der Pressform ein oder mehrere topographische Merkmale aufweisen, die in ihrer parallel zu der Oberfläche gemessenen kleinsten Abmessung kleiner als 15 µm sind oder in ihrer senkrecht zu der Oberfläche gemessenen kleinsten Abmessung kleiner als 15 µm sind, oder beides, und anschließendes Abkühlen des Polymerabschnitts, um ihn erstarren zu lassen und das Formteil zu erzeugen, das ein absichtlich in eine oder mehrere Oberflächen des Formteils eingeschmolzenes topographisches Merkmal aufweist, das in seiner parallel zu der Oberfläche gemessenen kleinsten Abmessung kleiner als 15 µm ist oder in seiner senkrecht zu der Oberfläche gemessenen kleinsten Abmessung kleiner als 15 µm ist, oder beides.

8. Verfahren nach Anspruch 7, wobei das topographische Merkmal in seiner parallel zu der Oberfläche gemessenen kleinsten Abmessung kleiner als 10 µm ist, oder wobei das Merkmal in seiner senkrecht zu der Oberfläche gemessenen kleinsten Abmessung kleiner als 10 µm ist, oder beides.

9. Verfahren nach Anspruch 7, wobei das topographische Merkmal in seiner parallel zu der Oberfläche kleinsten Abmessung kleiner als 5 µm ist, oder wobei das Merkmal in seiner senkrecht zu der Oberfläche gemessenen kleinsten Abmessung kleiner als 5 µm ist, oder beides.

10. Verfahren nach Anspruch 7, wobei das topographische Merkmal in seiner parallel zu der Oberfläche gemessenen kleinsten Abmessung kleiner als 1 µm ist, oder wobei das Merkmal in seiner senkrecht zu der Oberfläche gemessenen kleinsten Abmessung kleiner als 1 µm ist, oder beides.

11. Verfahren nach Anspruch 7, wobei das topographische Merkmal aus einer oder mehreren Schneisen, Rillen oder Kanälen besteht.

12. Verfahren nach Anspruch 7, wobei das topographische Merkmal in einer geordneten Anordnung vorhanden ist.

## Revendications

1. Pièce formée qui comprend une portion polymère composée en majeure proportion d'un polymère à cristaux liquides et qui comporte une caractéristique topographique délibérément moulée à l'état fondu dans une ou plusieurs surfaces de ladite pièce, ladite caractéristique mesurant moins de 15 µm dans sa plus petite dimension parallèlement à ladite surface, moins de 15 µm dans sa plus petite dimension perpendiculairement à ladite surface ou les deux.

2. Pièce formée selon la revendication 1, dans laquelle ladite caractéristique topographique mesure moins de 10 µm dans sa plus petite dimension parallèlement à ladite surface, moins de 10 µm dans sa plus petite dimension perpendiculairement à ladite surface ou les deux.

3. Pièce formée selon la revendication 1, dans laquelle ladite caractéristique topographique mesure moins de 5 µm dans sa plus petite dimension parallèlement à ladite surface, moins de 5 µm dans sa plus petite dimension perpendiculairement à ladite surface ou les deux.

4. Pièce formée selon la revendication 1, dans laquelle ladite caractéristique topographique mesure moins de 1 µm dans sa plus petite dimension parallèlement à ladite surface, moins de 1 µm dans sa plus petite dimension perpendiculairement à ladite surface ou les deux.

5. Pièce formée selon la revendication 1, dams laquelle ladite caractéristique topographique correspond à une ou plusieurs travées, rainures ou cannelures.

6. Pièce formée selon la revendication 1, dans laquelle ladite caractéristique topographique est arrangée selon un réseau ordonné.

7. Procédé pour la fabrication d'une pièce moulée, qui comprend le formage d'une portion polymère à l'état fondu dont la majeure proportion est un polymère à cristaux liquides, le placement de ladite portion polymère à l'état fondu dans un moule fermé sous une pression de 1 MPa au moins, ledit moule présentant sur une ou plusieurs de ses surfaces une ou plusieurs caractéristiques topographiques mesurant moins de 15 µm dans sa ou leur plus petite dimension parallèlement à ladite surface, moins de 15 µm dans sa ou leur plus petite dimension perpendiculairement à ladite surface ou les deux, puis le refroidissement de ladite portion polymère pour la solidifier, pour la production de ladite pièce moulée qui comporte une caractéristique topographique délibérément moulée à l'état fondu dans une ou plusieurs surfaces de ladite pièce, ladite caractéristique mesurant moins de 15 µm dans sa plus petite dimension parallèlement à ladite surface, moins de 15 µm dans sa plus petite dimension perpendiculairement à ladite surface ou les deux.

8. Procédé selon la revendication 7, dans lequel ladite caractéristique topographique mesure moins de 10 µm dans sa plus petite dimension parallèlement à ladite surface, moins de 10 µm dans sa plus petite dimension perpendiculairement à ladite surface ou les deux.

9. Procédé selon la revendication 7, dans lequel ladite caractéristique topographique mesure moins de 5 µm dans sa plus petite dimension parallèlement à ladite surface, moins de 5 µm dans sa plus petite dimension perpendiculairement à ladite surface ou les deux.

10. Procédé selon la revendication 7, dans lequel ladite caractéristique topographique mesure moins de 1 µm dans sa plus petite dimension parallèlement à ladite surface, moins de 1 µm dans sa plus petite dimension perpendiculairement à ladite surface ou les deux.

11. Procédé selon la revendication 7, dans lequel ladite caractéristique topographique correspond à une ou plusieurs travées, rainures ou cannelures.

12. Procédé selon la revendication 7, dans laquelle ladite caractéristique topographique est arrangée selon un réseau ordonné.
